# EUROPEAN PATENT SPECIFICATION

(11) **EP 1 744 344 B1**
(45) Date of publication and mention of the grant of the patent: **25.08.2010**
(21) Application number: 05015009.3
(22) Date of filing: 11.07.2005
(51) Int. Cl.: H01J 37/153, H01J 37/141, H01J 37/145

(54) **Electric-magnetic field generating element and assembling method for same**
Vorrichtung zur Erzeugung eines elektrisch-magnetischen Feldes und Aufbaumethode derselben
Dispositif de production d'un champ électro-magnétique et sa méthode d'assemblage

(43) Date of publication of application: 17.01.2007
(73) Proprietor: ICT Integrated Circuit Testing Gesellschaft für Halbleiterprüftechnik mbH, 85551 Heimstetten (DE)
(72) Inventor: Salvesen, Carlo, 84323 Massing (DE); Degenhardt, Ralf, 85652 Landsham (DE)
(74) Representative: Zimmermann, Gerd Heinrich

(56) References cited:
- EP-A- 1 045 425
- US-A- 4 962 313
- US-A- 5 021 670
- US-B1- 6 593 578
- HAIDER M ET AL: "DESIGN AND TEST OF AN ELECTRIC AND MAGNETIC DODECAPOLE LENS BAU UND ERPROBUNG EINER ELEKTRISCH-MAGNETISCHEN ZWOELFPOLLINSE" OPTIK, WISSENSCHAFTLICHE VERLAG GMBH.STUTTGART, DE, vol. 63, no. 1, 1982, pages 9-23, XP008051707 ISSN: 0030-4026

## Description

### FIELD OF THE INVENTION

The invention relates to an electric-magnetic field generating element and a multipole element comprising a plurality of such field generating elements.

### BACKGROUND OF THE INVENTION

Technologies like microelectronics, micromechanics and biotechnology have created a high demand in industry for structuring and probing specimens within the nanometer scale. On such a small scale, probing or structuring, e.g. of photomasks, is often done with electron beams which are generated and focused in electron beam devices like electron microscopes or electron beam pattern generators. Electron beams offer superior spatial resolution compared to e.g. photon beams due to their short wave lengths at a comparable particle energy.

One example for optical devices used in such electron beam apparatus are round lenses. Round lenses are used for focusing the corpuscular beams in conventional electron microscopes, electron and ion beam registration devices, ion processing and implantation devices as well as electron beam measuring devices. The geometry of these lenses which produce rotationally symmetrical electric and/or magnetic fields is optimized to small aberration constants. In systems in which rotationally symmetrical electric or magnetic fields which are not time-dependent and are free of space charge are used exclusively to produce the lens effect, the spherical aberration of the third order and the axial chromatic aberration of the first order, first degree, cannot be corrected in principle. For electrostatic fields, a zone having smaller than cathode potential acts like an electrostatic mirror reflecting the electron beam. Therefore, these aberrations limit the resolution and a correction thereof is only possible if one of the restrictions regarding the fields is waived, e.g. by introducing unround symmetries.

Multipole elements, e.g. quadrupoles, are used for example as adjustment means or stigmators in electron microscopes. For these elements the requirements regarding the shape of the field-generating components (pole pieces, electrodes), the accuracy of the adjustment to the optical axis and the long- and short-term stability are in any case substantially less than for systems for correction or reduction of spherical and chromatic aberrations. However, a high degree of accuracy is also desirable for adjustment components.

For example, Wien filters (see W. Wien, Ann. Phys. 65 (1898), page 444) can be used as correctors for charged particle beam optical systems. In such a Wien filter, electrodes and magnetic poles are simultaneously utilized to create both an electric field and a magnetic field. The two fields are tuned, or adjusted, to apply equal but opposite forces to charged particles having a certain nominal energy in the incident beam on the optical axis, so that these particles of nominal energy are not deflected. To improve the imaging properties of Wien filters, quadrupole or even multipole elements of higher order are added to the Wien filter, thus rendering the Wien filter a multipole element.

The design, manufacturing and assembly of such combined electric-magnetic multipole elements impose extremely high requirements on dimensional precision, positioning accuracy and also, in addition, stability during operation of the device comprising the multipole element. The difficulties to meet these requirements for electric-magnetic multipoles are further enhanced by the fact that the electrodes, which also serve as pole pieces, have to be placed directly within the vacuum.

In the combined electric-magnetic multipole elements which are known from Optik 60, No. 3(1982) page 307 to 326, the parts arranged in the vacuum, that is to say in particular the pole pieces and the electrodes, respectively, the exciting individual windings fixed on the pole piece mounting and the supply lines are cast integrally in synthetic resin, e.g. epoxy resin, in order to reduce the gas emitting surface. However, this embedding technique has the disadvantage that, in spite of maintaining its hardness for months in a vacuum, the synthetic resin as well as the varnish of the wires emits gas, and furthermore shrinks, becomes brittle and this deformation influences the magnetic properties of the multipole element. In addition, costly shielding of the epoxy resin is necessary in order to avoid charging by the corpuscular beam which is difficult to realize due to its complex design. Also, the integrally formed structure of this prior art multipole element is disadvantageous in terms of maintenance and readjustment or repair because the whole element has to be replaced or readjusted instead of, e.g., only the pole piece and electrode, respectively.

Due to the above described problems associated with exposing the coils to vacuum, it is desirable to place the coils for exciting the magnetic field outside the vacuum. Hence, the introduction of a vacuum-tight separation of the coils is advantageous. Also, the electrodes have to be electrically insulated from each other and from the coils when the electrodes serve also as pole pieces. Typically, the vacuum-tight seal is provided by a welding or brazing technique or by means of a gluing or molding process. Also, O-rings are used either alone or in combination with some of the aforementioned techniques for providing a vacuum-tight seal.

In US 5,021,670, the coil is mounted to an elongated part of the electrode and pole piece, respectively, located outside the beam tube. A vacuum seal is formed by metal-ceramic bonds or metal caps which are soldered to the elongated parts of the electrodes and pole pieces, respectively.

In US 6,593,578, the elongated electrodes and pole pieces, respectively, are inserted into a support structure made of ceramic. The coils are mounted on the elongated electrodes and pole pieces, respectively, outside the beam tube on spools. A vacuum-tight seal between the beam tube and the ceramic support structure is provided by brazing the pole pieces to the ceramic support structure.

However, it is difficult to maintain the positioning accuracy of the individual electrodes and pole pieces when a brazing technique is adopted. In this case, the vacuum-tight seal is formed by a metal-ceramic bond created by welding or brazing. Thus, the ceramic material is locally subject to high temperatures. These high temperatures induce tension forces in the ceramic-metal joint resulting in instabilities of the joints or even deformations. As a result, the optical properties of the multipole element deteriorate due to mechanical instabilities of the metal-ceramic joints. Also, the alignment accuracy of the pole pieces and electrodes, respectively, deteriorates due to such mechanical instabilities. Furthermore, brazing is difficult because of the different thermal expansion coefficients of the metal and ceramic materials involved. In the case of a brazing or soldering technique, the even distribution of the soldering flux is a complicated problem. Moreover, these problems become even more severe when they have to provide a vacuum-tight seal. Glues or resins do not provide alternatives since they suffer from the disadvantages mentioned above, i.e. a high outgassing rate, degradation during vacuum operation and shrinking.

Furthermore, all the prior art solutions outlined above have the problem in common that during operation, particularly at higher excitation of the coils, the heat created by the coils causes mechanical instabilities and deformations of the metal-ceramic joints resulting in deformations of the electromagnetic field and, thus, drifts and instabilities of the charged particle beam. However, in some applications it is especially desirable to excite a multipole element up to a point where particles entering the multipole element follow oscillating trajectories inside the multipole element. For this purpose, relatively high excitation of the multipole element is necessary.

It is therefore an object of the present invention to overcome the disadvantages associated with the prior art at least partially.

### SUMMARY OF THE INVENTION

This object is solved by an electric-magnetic field generating element according to claim 1, and a multipole element according to claim 24.

Further advantages, features, aspects and details of the invention are evident from the dependent claims, the description and the accompanying drawings.

In the context of the present applications, the term "electric-magnetic field generating element" comprises elements for the generation of purely magnetic fields as well as elements for the generation of electromagnetic fields. Therefore, in the following description the reference to a pole piece, which is used for generating a purely magnetic field, should be understood also as a reference to an element combining a pole piece with an electrode and, thus, being designed for generating an electromagnetic field. Exceptions from this rule will be expressly mentioned where necessary.

According to a first aspect of the present invention, a field generating element for a charged particle beam apparatus is provided. Therein, the charged particle beam may be an electron beam, an ion beam or any other beam of charged particles. The field generating element comprises a pole piece and a yoke for closing the magnetic circuit. The pole piece is attached to the yoke. Furthermore, the field generating element comprises a coil which encircles a part of the magnetic circuit, e.g. the pole piece or the yoke. The coil is housed within a vacuum-tight chamber or container to which a support or holder is attached. Typically, the container is made of an essentially nonmagnetic material so that it does not cause any deteriorating magnetic fields. The support is designed to maintain a clearance between the container and the pole piece as well as between the container and the yoke. In other words, the container accomodating the coil is spaced from the magnetic circuit of the field generating element.

The field generating element according to the above described design possesses several advantages: Since the chamber accomodating the coil is not in contact with the pole piece and the yoke, no heat conductance to the pole piece and the yoke occurs. It should be understood that, in this context, the clearance is chosen to provide sufficient high voltage electric strength taking into account the applicable machining tolerance and surface quality. Thus, mechanical deformations or instabilities resulting in a misalignment of the pole piece, especially at higher coil excitations, are prevented so that drifts and instabilities of the charged particle beam resulting from such deformations and instabilities are almost excluded. Consequently, for higher coil excitations the field generating element can be either built more compact, i.e. shorter in height, or, alternatively, for a given height of the field generating element a more stable charged particle beam and, therefore, better performance can be achieved. Also, water cooling of the field generating element is dispensable. In addition, electrical insulation of the coil is inherent to the design. A further advantage is the modular design of the field generating element so that individual parts of it may be replaced after assembly. Particularly, it is possible to fully disassemble the field generating element and to reassemble it if desired since the individual parts of the field generating element are not welded together or cast integrally in resin.

Furthermore, it is important to note that metal-ceramic bonds at the pole piece as well as integral casting of the coil can be omitted in the manufacturing of a field generating element according to an embodiment of the present invention. Thus, precise and stable positioning and vacuum strength of the field generating element can be attained. In this context, the term vacuum strength refers to vacuum tightness, a low outgassing rate as well as to applicability up to a high vacuum which is at least 10⁻⁷ Torr.

Another advantage of the design according to the first aspect of the present invention relates to the vacuum-tight sealing of the coil. When a coil heats up during excitation outgassing material of the varnish or sealing resin and of spaces between the wires will be discharged from the coil surface and, thus, deteriorate the vacuum within the charged particle beam column. Furthermore, due to its large surface the coil can collect a considerable amount of dust and other debris when open to its environment. This contaminating material will also be discharged upon heating and will deteriorate the vacuum. However, the separation of the coil from the column vacuum by the vacuum-tight container avoids the aforementioned sources of contamination. It should be understood that the vacuum-tight container may be formed of a rigid material or of a flexible material as long as it maintains a vacuum-tight seal against the column vacuum and does not contaminate the vacuum.

According to another aspect of the invention, the support or holder keeps the coil container not only spaced from the pole piece and the yoke but also from the other parts within the magnetic circuit of the charged particle optical device. Typically, these other parts are shields for shielding internal fringe fields which may deteriorate the optical properties of the field generating element. Typically, the yoke and/or the shields comprise a through hole through which the support or holder extends. Preferably, a cross section of the through hole is larger than a cross section of the support. For example, the holder may exit through an upper or lower shield. In this case, the upper or lower shield comprises a through hole through which the holder extends. In this case, a cross section of the through hole is larger than a cross section of the holder. Thus, a clearance is maintained between the support or holder and the yoke or shields or any other part of the electric-magnetic field generating element. It should be understood that, in this context, the clearance is chosen to provide sufficient high voltage electric strength taking into account the applicable machining tolerance and surface quality.

Since the coil container is not only spaced from the pole piece and the yoke but also from other parts within the magnetic circuit of the field generating element, mechanical deformations and instabilities due to the heat load of the coil can almost be excluded.

According to an embodiment of the present invention, the coil is at atmospheric pressure within the vacuum-tight container. Typically, a fluid conduit or duct is mounted between a column housing of the charged particle beam apparatus and the vacuum-tight container. In this context, it should be understood that the fluid can be a gas or a liquid. The fluid conduit provides a vacuum-tight passage between the inside space of the coil container and an atmosphere outside the column housing of the charged particle beam apparatus. Therefore, a vacuum-tight sealing between the duct and the column housing is provided. Typically, the sealing is provided by an O-ring, e.g. made of Viton^{®}, or a metal gasket. However, also other suitable sealing means may be provided.

Thus, heat generated by the coil or the coils located inside the coil container can be effectively transferred to the outside atmosphere and/or the column housing. Since the fluid conduit or duct connects the coil directly to the column housing, the thermal load of the coil is directly transferred to the column housing and the atmosphere outside the column, which is of special importance when the excitation of the coil is high. Thus, an effective heat transfer mechanism for the coil is established.

The fluid conduit or duct can be formed as a stiff hollow tubular member. In this case, the duct may simultaneously serve as the container support. However, the duct may be provided as a separate member in which case it may be formed as a flexible member, e.g. a vacuum-tight hose. Typically, the fluid conduit or duct also guides coil supply lines. Typically, the duct is mounted to the column housing from the inside or the outside. Due to the vacuum-tight duct, the coil is separated from the column vacuum and in communication with the outside atmosphere.

According to an even further embodiment of the present invention, the pole piece also serves as an electrode. For this purpose, the pole piece is connected to a voltage source by a voltage supply line. Furthermore, the pole piece is electrically insulated from the yoke to which it is usually attached. Typically, this insulation is realized by an insulating foil, e.g. made of polyimide available from DuPont under the trademark name Kapton. Typically, the pole piece is attached to the yoke by screw bolts which are inserted into ceramic bushings to electrically insulate them from the yoke. The ceramic bushings are disposed in through holes within the yoke and further extend inside the pole piece. Typically, the ceramic bushings are manufactured with very high precision and are tightly-fitted into the pole piece so that they can guide the pole piece with high accuracy.

A field generating element according to the above embodiment can additionally generate electrostatic fields. Thus, such a combined electric-magnetic field generating element is ideal for use in a multipole element. Since the coil's container is spaced from the pole piece and the electrode, respectively, the electrical insulation of the coil and the electrode from each other is inherent to the design.

According to another aspect of the present invention, a multipole element is provided which comprises field generating elements as they have been described above. Typically, the vacuum-tight cases of the field generating elements are connected to each other so that they form a self-supporting structure.

A self-supporting structure of the interconnected containers is advantageous since it can be prefabricated and exhibits high mechanical strength. Since the self-supporting structure is not in contact with any other part of the multipole element, particularly not with the pole pieces and the yokes or shields, mechanical deformations due to heat load from highly excited coils can be avoided. Typically, the connections are formed detachably so that the self-supporting structure can be disassembled and reassembled. Thus, individual containers can be replaced for maintenance or repair.

### BRIEF DESCRIPTION OF THE DRAWINGS

Some of the above indicated and other more detailed aspects of the invention, will be described in the following description and partially illustrated with reference to the figures. Therein:
Fig. 1 shows a field generating element according to an embodiment of the present invention.
Fig. 2 shows a field generating element according to another embodiment of the present invention.
Fig. 3 shows a field generating element according to a further embodiment of the present invention.
Fig. 4 shows a cross section of a multipole element according to another aspect of the present invention.
Fig. 5 is a view of a multipole element according to an embodiment of the present invention.
Fig. 6 shows a multipole element according to a further embodiment of the present invention having a different arrangement of the vacuum-tight containers.
Figs. 7A and 7B show a partial view of a multipole element according to an embodiment of the present invention.
Figs. 8 to 11 show different embodiments of a pole piece rear surface according to embodiments of the present invention.

### DETAILED DESCRIPTION OF THE DRAWINGS

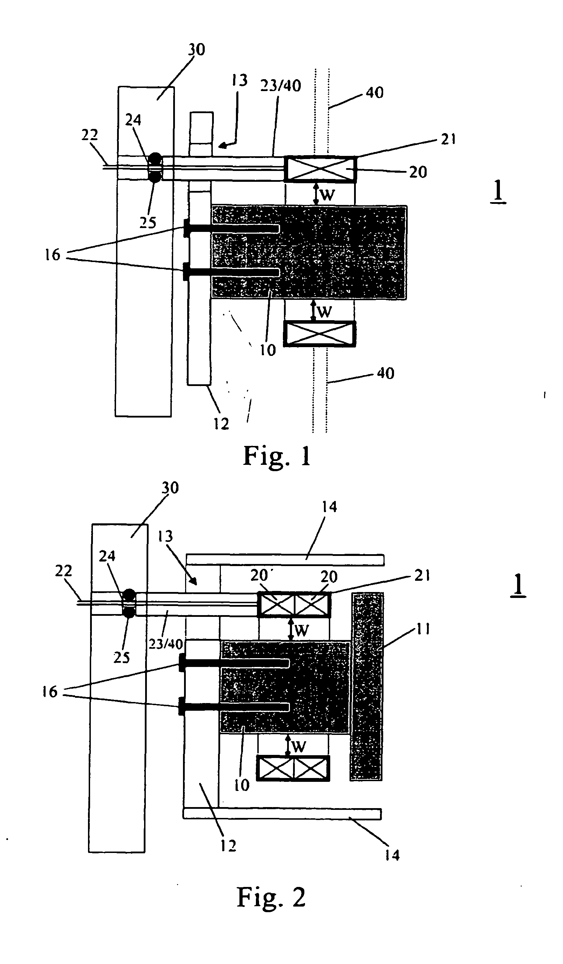

Fig. 1 shows an electric-magnetic field generating element according to an embodiment of the present invention. The electric-magnetic field generating element shown in Fig. 1 comprises a pole piece 10 which is attached to a yoke 12 for guiding the magnetic flux. The pole piece is attached to yoke 12 by screw bolts 16. The field generating element generates a magnetic field by use of a coil 20 accommodated in a container 21. Container 21 is formed in a vacuum-tight manner so that it seals coil 20 against the vacuum in the column of the charged particle beam. Typically, the container is sealed in a vacuum-tight manner by welding, soldering or brazing. Additionally or alternatively, also O-rings or metal gaskets can be used for the vacuum-tight seal. Inside container 21, coil 20 is at atmospheric pressure. The container 21 surrounds a pole piece 10 which guides the magnetic flux generated by coil 20. Pole piece 10 and container 21 are spaced by a clearance of width W. The width W is mainly determined by two factors: electric strength with respect to high voltages and machining tolerance. Accordingly, the width W is chosen so that the resulting configuration has sufficient electric strength even for high voltages occurring together with high coil excitations. Thereby, the machining tolerance has to be taken into account in that a minimum clearance must be provided. A typical value for width W is 3 mm for a field generating element with a height of 50 mm to 100 mm. Furthermore, container 21 is also spaced by a clearance from the yoke 12. To maintain container 21 in a position spaced from the pole piece 10 and the yoke 12, a holder 40 is provided.

The embodiment of Fig. 1 shows alternative realizations of the holder 40. As a first alternative, a duct 23 is mounted between container 21 and a column housing 30 of the charged particle beam apparatus. Duct 23 extends horizontally from container 21 through an opening 13 in the yoke 12 to the column housing 30. The cross section of opening 13 is larger than the cross section of duct 23 so that duct 23 is spaced from yoke 12. Duct 23 provides a vacuum-tight conduit between the inside of container 21 and the atmosphere outside the column housing 30. Therefore, a sealing 25, e.g. an O-ring or a metal gasket, is provided between duct 23 and column housing 30. Duct 23 is formed as a rigid tubular member so that it can hold container 21 in a predetermined position. Thus, duct 23 serves as a holding member 40 for container 21. The duct may be formed integrally with the container by primary forming or may be attached to it by brazing or welding techniques. Furthermore, duct 23 is made of heat-conducting material so that it further provides heat transfer from the vacuum-tight container 21 to the housing 30 or to the outside of the charged particle apparatus. It is also possible to provide super-conducting coils within vacuum-tight container 21. Then, coolant supply for the super-conducting coils can be provided by duct 23. Accordingly, duct 23 is designed to transfer heat from the inside of container 21 to the column housing and the outside of the column by conductance and/or convection.

As a further alternative, the holder 40 may also be provided by an upwardly extending member 40 shown in dotted lines in Fig. 1. Upwardly extending member 40 can be attached to column housing 30 or to a plate member (not shown) located above the field generating element. Alternatively, the holder 40 may also be provided by a downwardly extending member 40 also shown in broken lines in Fig. 1. Downwardly extending member 40 can be attached to column housing 30 or to a bottom plate member (not shown) located below the field generating element. Both the upwardly and downwardly extending members 40 may be formed as simple solid rods or as ducts similar to horizontally extending duct 23 described above. Furthermore, a duct 23 can be provided in addition to the vertically extending holder 40. In this case, the duct may be formed as a flexible vacuum-tight hose since rigidity of the duct is not required.

In the embodiment shown in Fig. 1, supply lines 22 for the coil 20 are accommodated within duct 23, wherein the supply lines 22 are connected to current drivers (not shown) outside column housing 30. The supply lines 22 are guided from the inside of column housing 30 to the outside via a feed-through 24 which is sealed vacuum-tightly by a sealing 25. Sealing 25 may be formed as an O-ring or a metal gasket and may be selected according to the specific requirements of the apparatus as long as it provides vacuum-tight sealing.

The above described electric-magnetic field generating element has the following advantages over conventional designs: Since the container 21 of coil 20 is not in contact with the pole piece 10 and the yoke 12, no direct heat transfer from the coil 20 to pole piece 10 and yoke 12 occurs. Thus, misalignment and instabilities of the pole piece 10, especially at higher coil excitations, are prevented so that, in turn, drifts and instabilities of the charged particle beam resulting from such misalignment and instabilities are avoided. Consequently, for higher coil excitations the field generating element can be either built more compact, i.e. shorter in height, or, alternatively, for a given height of the field generating element a more stable charged particle beam and, therefore, better performance can be achieved. Since the duct 23 connects the coil 20 directly to the column housing, the thermal load generated by the coil 20 is directly transferred outside the column 30 and to the column housing 30, especially when the coil 20 is at atmospheric pressure and the excitation of the coil is high. Thus, an effective heat transfer mechanism for the coil is established and water-cooling is dispensable.

Fig. 2 shows a field generating element according to another embodiment of the present invention. It is similar to the embodiment shown in Fig. 1 but has a more complex design. Further to the elements described with reference to Fig. 1, the embodiment shown in Fig. 2 comprises a front pole piece 11 attached to the pole piece 10. Typically, the front pole piece 11 and the pole piece 10 are integrally formed. However, front pole piece 11 is elongated to shield the coil 20.

Furthermore, an additional coil 20' is disposed in the container 21. Coil 20' can be used to provide a corrective magnetic field. It should be understood that even more additional coils may be provided in container 21 and that the cross sectional shape of container 21 may be adapted to the number and shape of the coils within.

At the upper and lower ends of yoke 12, shielding plates 14 are provided. Shielding plates 14 limit the extension of internal magnetic fringe fields. In case also electrostatic fields are generated by the field generating element like in the embodiments described below, field shields 14 also limit the extension of the electrostatic field. Thus, the influence of these fringe fields onto the charged particle beam is minimized and the optical properties are not deteriorated.

Since in the above described embodiment the container 21 and the duct 23 are not only spaced from the pole piece 10, 11 but also from other parts of the field generating element like the yoke 12 and the shielding plates 14, mechanical deformations due to the heat load generated particularly by a highly excited coil can almost be excluded. In case of upwardly or downwardly extending holder, openings have to be provided within a respective shielding plate 14, wherein the cross section of the opening must be larger than the cross section of the holder so that no heat transfer from the holder to the shielding plate 14 occurs.

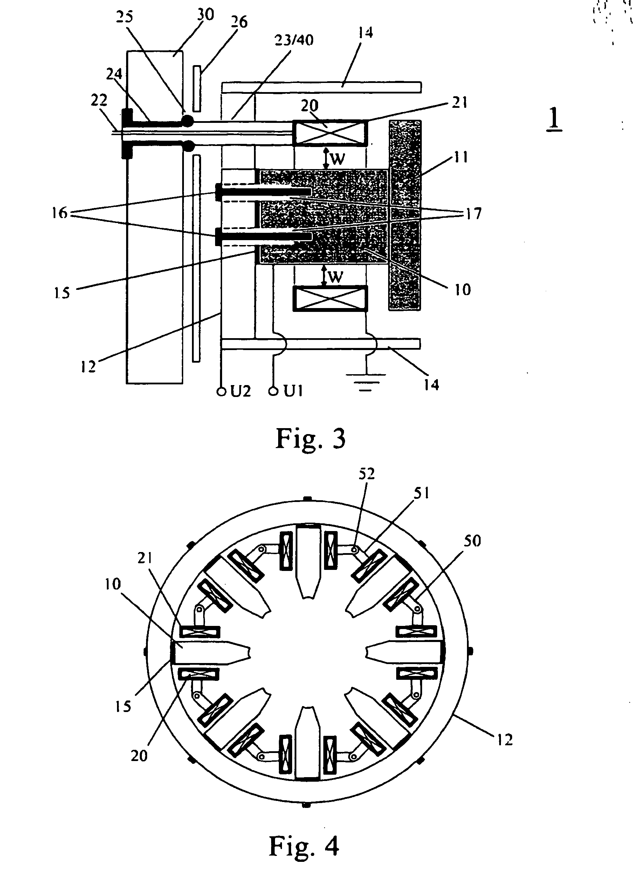

Fig. 3 shows a field generating element according to a further embodiment of the present invention. This embodiment differs from the embodiment shown in Fig. 2 in some aspects. A first difference is that the pole pieces 10, 11 also serve as electrodes for generating an electrostatic field. For this purpose, pole piece 10 is connected to a voltage source by a supply line. Thus, a voltage U 1 can be applied to pole piece 10, 11. Alternatively, the electrical connection can also be made at pole piece 11 or via the screw bolts 16 for attaching the pole piece to the yoke. In either case, the connection lines to the voltage source may be guided out of the charged particle apparatus through duct 23 or by other means. When pole pieces 10, 11 simultaneously serve as electrodes, yoke 12 must be electrically insulated from the combined pole piece/electrode 10, 11. For this purpose, an insulating foil 15 is disposed between yoke 12 and combined pole piece/electrode 10, 11. Typically, this insulating foil is made of polyimide available from DuPont under the trademark name Kapton. Typically, the combined pole piece/electrode is attached to the yoke by screw bolts 16 which are inserted into ceramic bushings 17 extending through the yoke (dashed lines) to electrically insulate the screw bolts there from. The ceramic bushings 17 are further extending into bores provided at a rear surface of the combined pole piece/electrode. Typically, the ceramic bushings are manufactured with very high precision and are tightly-fitting into the bores so that the pole pieces/electrodes can be also positioned with very high accuracy.

The above described electric-magnetic field generating element is capable of generating a magnetic and an electrostatic field. Since the coils 20, 20' and the electrodes 10, 11 are supplied by individual current/voltage sources, the magnetic and electrostatic fields generated by the element can be individually adjusted. Therefore, this electric-magnetic field generating element is predestined for use in an electric-magnetic multipole element.

Furthermore, the embodiment shown in Fig. 3 has an additional shield 26 disposed between the yoke 12 and column wall 30. Shield 26 protects the field generating element against external fields which may influence and deteriorate the field generated by the field generating element. Like yoke 12, also shield 26 has an opening through which duct 23 can be guided. Similarly, this opening is spaced from duct 23 so that no heat transfer between duct 23 and the shield 26 occurs. It should be understood that shield 26 is an optional feature and may also be added to other embodiments of the present invention, especially the embodiments shown in Figs. 1 and 2.

Moreover, Fig. 3 shows an optional arrangement of the fixing of duct 23 to the column 30 and of the guidance of supply lines 22 to the exterior of the column. As shown in Fig. 3. duct 23 can be fixed from the outside of the column 30.

Furthermore, in any of the above described embodiments, the magnetic circuit formed by the yoke 12 and/or the shielding plates 14 may be connected to a voltage source U2 to bring the magnetic circuit on a predetermined potential. However, in this case it is important to take into account the potential difference between the magnetic cage and the holder when dimensioning the cross sections of the openings in the yoke and/or the shielding plates. Otherwise, undesirable electrical discharge may occur.

Fig. 4 shows a cross-section of a multipole element assembled from electric-magnetic field generating elements. Therein, eight field generating elements according to the above embodiment of the present invention are arranged with eightfold symmetry around the optical axis. The number eight should be understood to be exemplary, but typically the number of field generating elements of a multipole element is even. Each of the vacuum-tight containers 21 of the coils 20 has at least one flange 50, 51 on either side thereof for connection with an adjacent container. Flanges 50 are located above flanges 51 when seen in an axial direction of the column. Each of the flanges 50, 51 has an opening through which a screw bolt 52 can be inserted. When assembling the multipole element shown in Fig. 4, the flanges 50, 51 of adjacent field generating elements are aligned so that their openings overlap. Then, a screw bolt 52 is inserted into the openings and fixed. Thus, each of the containers 21 is detachably fixed to its neighboring containers and, as a result, a self-supporting structure is obtained. According to a further embodiment of the present invention, adjacent vacuum-tight containers 21 are electrically connected by microconnectors (not shown). For example, these microconnectors can be comprised in the above-described flange structures. Due to the microconnectors, the vacuum-tight containers 21 are electrically connected to each other so that it is not necessary that each container 21 has its own duct for leading the supply lines to the outside of the housing 30. Instead it is possible that a duct is attached to only a single container 21 and that the coils in the remaining containers are supplied via the microconnectors.

Since the electric-magnetic field generating elements are detachably connected to each other and since the individual components of each of the electric-magnetic field generating elements are detachably connected to each other, the multipole element can be fully disassembled and, if desired, again reassembled due to this modular design. Therefore, maintenance and replacement of parts is facilitated. Furthermore, the adjustment and alignment accuracy does not deteriorate due to disassembly so that the field generating elements of the multipole element may be readjusted after maintenance or replacement with the same precision as during initial assembly. For example, in a multipole element having outer dimensions of 100 mm, the pole pieces can be adjusted with an accuracy of 5 µm.

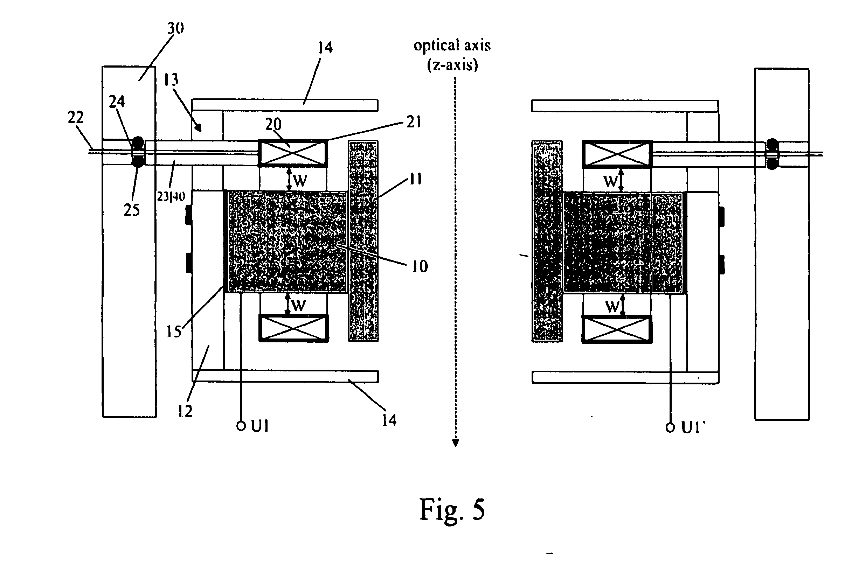

Fig. 5 is a cross sectional view of the multipole element shown in Fig. 4. It is apparent from Fig. 5 that each individual electric-magnetic field generating element has the configuration of the embodiment shown in Fig. 3. Especially, the voltage and/or current supply can be individually controlled and adjusted for each of the field generating elements and for each coil and electrode of an individual field generating element. Thus, very accurate and complex field patterns can be generated. Since the coils 20 are accommodated in their vacuum-tight containers 21 and are spaced from the combined pole pieces/electrodes 10, 11, the precision of the field generation can also be maintained at higher coil excitations when considerable heat load is generated. Then, the heat is transferred outside the column via the container and the duct without causing mechanical instabilities or misalignments of other parts of the multipole element.

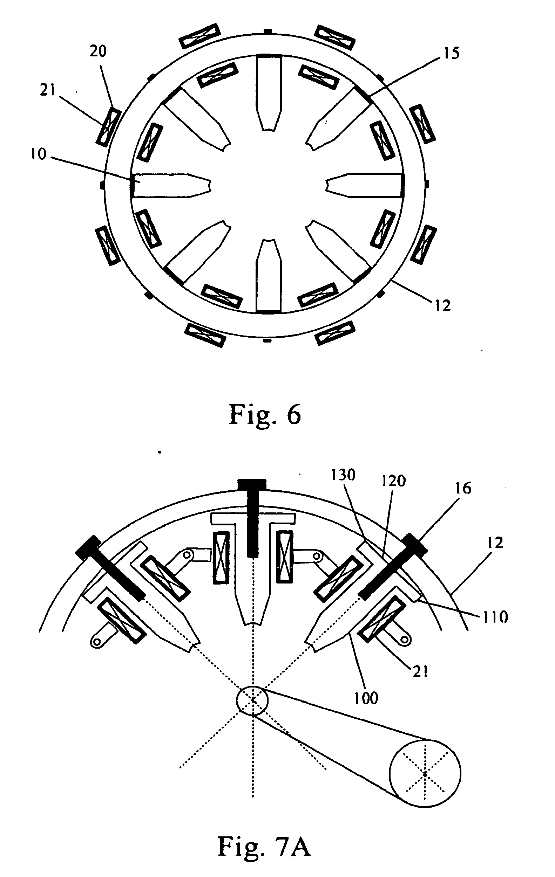

An alternative embodiment of the multipole element of Fig. 4 is shown in Fig. 6. Therein, the vacuum-tight containers 21 are mounted on the yoke 12 instead on the pole pieces 10. In this embodiment, it is not necessary to provide through holes 13 for holder in the yoke. However, the yoke 12 is adapted to be opened so that it can be inserted into the central opening of the container.

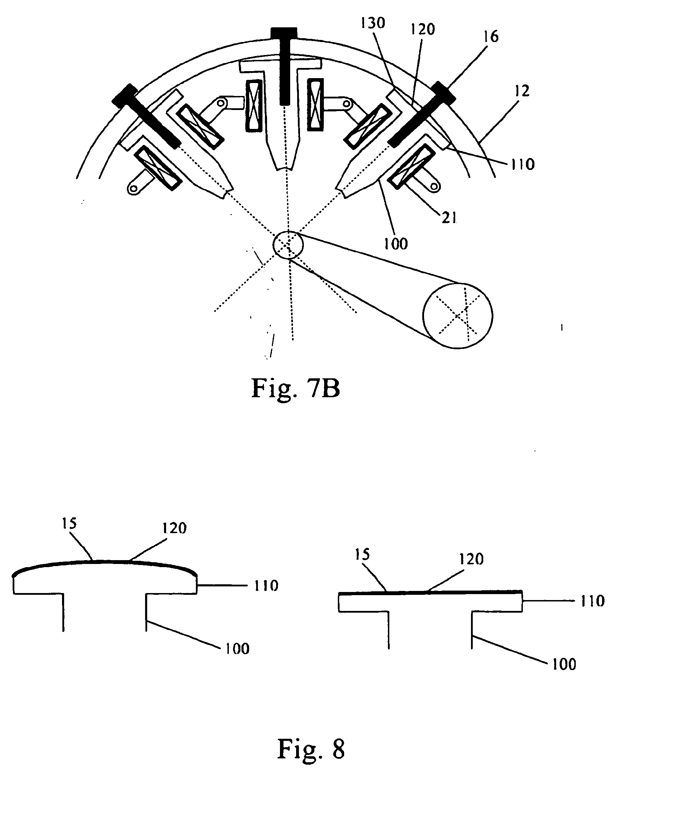

A further aspect of the present invention relates to the alignment of the field generating elements and is now described with reference to Figs. 7 to 11. Fig. 7A shows an enlarged view of an arrangement of field generating elements, e.g. similar to the arrangement shown in Fig. 4. The pole pieces shown in Fig. 7A are correctly aligned so that their imaginary axes (dashed lines) meet in a single point (see enlarged inset in Fig. 7A). Fig. 7B shows a case where the middle pole piece is not correctly aligned. Therefore, its imaginary axis does not extend through the center point (see enlarged inset in Fig. 7B). As a result, the field geometry, i.e. the symmetry, of the multipole element of Fig. 7B is distorted. Consequently, such a distortion of the field geometry should be avoided in that the pole pieces 100 are correctly aligned.

In the prior art apparatus, e.g. of US 6,593,578, the alignment of the pole pieces was achieved by inserting the pole pieces into a ceramic ring to which the pole pieces are brazed. In a multipole element according to an embodiment of the present invention the ceramic ring is dispensable and, therefore, omitted. Therefore, the alignment of the pole pieces can be adjusted through a proper design of the rear surface of the pole pieces as will be described below.

In Fig. 7A, each of the field generating elements is configured according to another embodiment of the present invention and comprises a pole piece 100 having a laterally extended rear portion 110. The rear portion 110 has a rear surface 120 facing a cylindrical yoke 12. The yoke 12 may comprise several parts or may be integrally formed. If the yoke 12 comprises several parts, the yoke could be parted vertically, horizontally or in any other desired direction. In the embodiment shown in Fig. 7A, the rear surface 120 is in contact with yoke 12 only at specific contact regions 130. These contact regions define the spatial alignment of the pole piece and, thus, are important for the field geometry provided by a multipole element formed from such pole pieces. Therefore, a proper design of the contact regions 130 at the rear surface 120 provides proper alignment of the pole pieces 100. Thus, it is possible to control the alignment accuracy through a design and manufacturing process. The difficult control of a metal-ceramic brazing process can be avoided. Furthermore, the misalignment at the front surface of the pole piece 100 is only very small compared to the misalignment at the rear surface 120 due to the aspect ratio of the pole piece 100. Thus, the alignment can be provided with higher accuracy compared with the prior art apparatus.

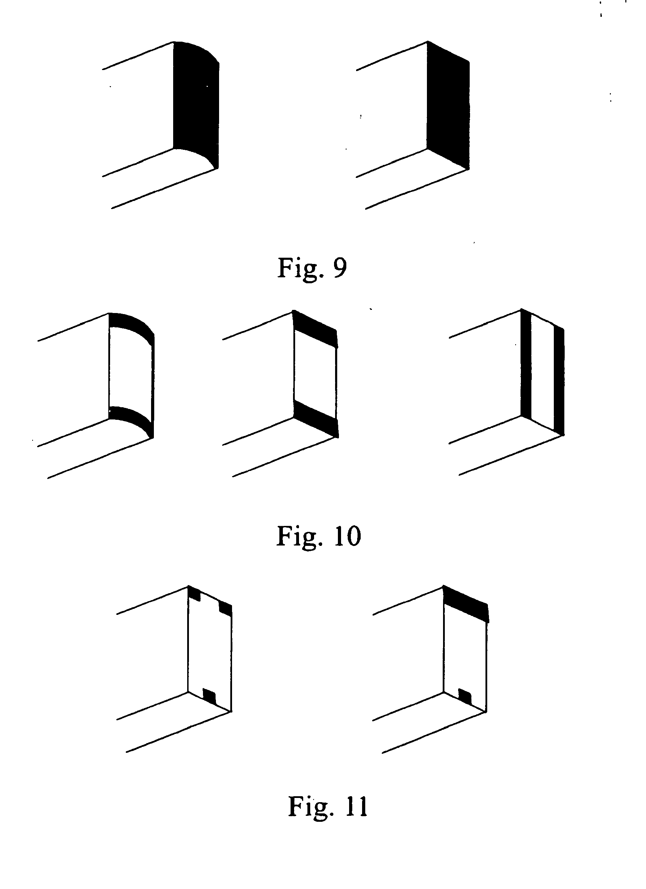

Fig. 8 shows two different basic shapes of the rear surface 120. On the left hand side of Fig. 8, the rear surface 120 has the shape of a circular arc. A perspective view of the curved rear surface is shown on the left hand side of Fig. 9. The curvature of rear surface 120 is adapted to the curvature of the inner surface of the cylindrical yoke 12. Thus, rear surface 120 fits to the inner surface of yoke 12. The contact region of the rear surface 120 is covered with an insulating material 15, e.g. Kapton foil, for electric insulation of pole piece 100 and yoke 12. Alternatively, an insulating foil 15 is inserted between the rear surface 120 and the yoke 12.

On the right hand side of Fig. 8, the rear surface 120 has a planar shape as shown in Figs. 7A and 7B. A perspective view of the planar rear surface is shown on the right hand side of Fig. 9. When used with a cylindrical yoke, only the outermost left and right regions of the planar rear surface 120 will contact the yoke (see Figs. 7A and 7B). However, the yoke 12 may also be polygonal and, thus, planar on its surface opposing rear surface 120 of the pole piece 100.

Also, the yoke may have planar recesses into which the rear surface 120 of the pole piece fit. In this case, the yoke itself may have an arbitrary shape. However, in this case, also the upper, lower and side surfaces of the pole piece must be covered with insulating material.

According to another embodiment, only the outermost left and right portions of the rear surface are curved whereas the center portion in-between is planar.

A further embodiment of the present invention is shown in Fig. 10 where only specific regions (stripes) of the rear surface are provided as contact regions. These regions are elevated with respect to the rest of rear surface 120 so that contact between the pole piece and the yoke is only made at these contact regions. The regions may be formed as horizontal or vertical stripes.

An even further embodiment of the present invention is shown on the left hand side of Fig. 11 where the elevated contact regions are not stripe-shaped but point-shaped. In the specific example shown in Fig. 11 three points serve as contact regions between the pole piece and the yoke. However, any number of point-shaped contact regions as well as any combination with stripe-shaped contact regions may be selected according to the specific application. An example of a combination with a horizontal stripe in the upper portion of the back surface and a single point in the lower portion of the rear surface of the pole piece is shown on the right-hand side of Fig. 11.

It should be understood that in the embodiments shown in Figs. 8 to 11, the contact between the rear surface of the pole pieces and the yoke is not necessarily a direct contact but can also be an indirect contact. For example, an insulating foil may be placed in-between the rear surface of the pole piece/electrode and the yoke.

## Claims

1. An electric-magnetic field generating element (1), comprising
a pole piece (10),
a yoke (12) to which the pole piece (10) is attached,
at least one coil (20),
**characterised in that**
a vacuum-tight container (21) accomodating the at least one coil (20), and
a holder (40, 23) adapted to hold the vacuum-tight container (21) such that the vacuum-tight container (21) is spaced from the pole piece (10) and from the yoke (12).

2. The field generating element (1) according to claim 1, wherein the vacuum-tight container (21) surrounds the pole piece (10).

3. The field generating element (1) according to claim 1, wherein the vacuum-tight container (21) surrounds the yoke (12).

4. The field generating element (1) according to any of the preceding claims, wherein the holder (40, 23) is attachable to a housing (30) of the charged particle beam apparatus.

5. The field generating element (1) according to any of the preceding claims, wherein
the yoke (12) comprises at least one opening (13), and the holder (40, 23) extends through the opening (13) of the yoke (12),
wherein a cross-section of the opening (13) is larger than a cross-section of the holder so that the holder (40, 23) is spaced from the yoke (12).

6. The field generating element (1) according to any of the preceding claims, further comprising
at least one shielding plate (14) for limiting fringe fields, the at least one shielding plate (14) being spaced from the vacuum-tight container (20).

7. The field generating element (1) according to claim 6, wherein
the at least one shielding plate (14) comprises at least one opening, and the holder (40, 23) extends through the opening of the shielding plate (14), and
wherein a cross-section of the opening is larger than a cross-section of the holder (40, 23) so that the holder is spaced from the at least one shielding plate (14).

8. The field generating element (1) according to any of the preceding claims, further comprising
a duct (23) adapted to provide a vacuum-tight conduit for fluid communication of the inside of the container (21) and the outside of the charged particle beam apparatus.

9. The field generating element (I) according to any of the preceding claims, further comprising
a duct (23) made of heat-conducting material and adapted to conduct heat from the inside of the container (21) to a housing (30) and/or to the outside of the charged particle beam apparatus.

10. The field generating element (1) according to claim 8 or 9, wherein
the duct (23) houses supply lines (22) for the at least one coil (20).

11. The field generating element (1) according to any of claims 8 to 10,
wherein
the duct is mountable between the container (21) and a housing (30) of the charged particle beam apparatus.

12. The field generating element (1) according to claim 11, wherein
the duct is mountable to the housing (30) of the charged particle beam apparatus and fixable from outside the housing (30).

13. The field generating element (1) according to any of claims 8 to 12, wherein the duct (23) serves as the holder (40).

14. The field generating element (1) according to any of the preceding claims, wherein at least one further coil (20') is accommodated in the vacuum-tight container (21).

15. The field generating element (1) according to any of the preceding claims, wherein the pole piece (10) comprises an elongated front piece (11).

16. The field generating element (1) according to any of the preceding claims, wherein
said pole piece (11, 10) further serves as an electrode and is connected to a voltage source (U1, U1) by a voltage supply line, wherein the pole piece (10, 11) is electrically insulated from the yoke (12).

17. The field generating element (1) according to claim 16, wherein
the yoke (12) is electrically insulated from the pole piece (10, 11) by an insulating foil (15) and ceramic bushings (17).

18. The field generating element (1) according to any of the preceding claims, wherein at least a part of a rear surface (120) of the pole piece (10, 100) is curved, wherein the curvature is adjusted to fit with a respective inner curvature of the yoke (12).

19. The field generating element (1) according to any of the preceding claims, wherein a rear surface (120) of the pole piece (10, 100) is planar.

20. The field generating element (1) according to any of the preceding claims, wherein the rear surface (120) comprises at least one elevated contact region (130) for being in contact with the yoke (12).

21. The field generating element (1) according to claim 20, wherein at least one elevated contact region (130) is stripe-shaped.

22. The field generating element (1) according to claim 20 or 21, wherein at least one elevated contact region (130) is point-shaped.

23. The field generating element (1) according to any of the preceding claims, wherein
the components of the field generating element (1) are detachably connected to each other so that the field generating element (1) can be disassembled and reassembled to the same precision and accuracy.

24. A multipole element comprising a plurality of field generating elements (1) according to any of claims 1 to 23.

25. The multipole element according to claim 24, wherein the number of field generating elements (1) is even.

26. The multipole element according to claim 24 or 25, wherein the vacuum-tight containers (21) of the field generating elements (1) are connected to each other to form a self-supporting structure.

27. The multipole element according to claim 26, wherein the vacuum-tight containers (21) of the field generating elements (1) are detachably connected to each other.

28. The multipole element according to any of claims 24 to 27, wherein the vacuum-containers (21) are electrically connected to each other by microconnectors.

## Patentansprüche

1. Elektro-magnetisches Feld erzeugendes Element (1), aufweisend
ein Polstück (10),
ein Joch (12), mit welchem das Polstück (10) befestigt ist,
mindestens eine Spule (20),
**dadurch gekennzeichnet, dass**
einen vakuumdichter Behälter (21), der die mindestens eine Spule (20) aufnimmt, und
einen Halter (40, 23), welcher angepasst ist, den vakuumdichten Behälter (21) zu halten, so dass der vakuumdichter Behälter (21) von dem Polstück (10) und von dem Joch (12) beabstandet ist.

2. Felderzeugendes Element (1) nach Anspruch 1, wobei der vakuumdichte Behälter (21) das Polstück (10) umgibt.

3. Felderzeugendes Element (1) nach Anspruch 1, wobei der vakuumdichte Behälter (21) das Joch (12) umgibt.

4. Felderzeugendes Element (1) nach einem der vorangehenden Ansprüche, wobei der Halter (40, 23) an einem Gehäuse (30) der Ladungsteilchenstrahlvorrichtung befestigbar ist.

5. Felderzeugendes Element (1) nach einem der vorangehenden Ansprüche, wobei
das Joch (12) mindestens eine Öffnung (13) aufweist, und der Halter (40, 23) durch die Öffnung (13) des Jochs (12) verläuft,
wobei ein Querschnitt der Öffnung (13) größer als ein Querschnitt des Halters ist, so dass der Halter (40, 23) von dem Joch (12) beabstandet ist.

6. Felderzeugendes Element (1) nach einem der vorangehenden Ansprüche, ferner aufweisend
mindestens eine Abschirmplatte (14) zum Begrenzen von Streufeldern, wobei die mindestens eine Abschirmplatte (14) vom vakuumdichten Behälter (20) beabstandet ist.

7. Felderzeugendes Element (1) nach Anspruch 6, wobei
die mindestens eine Abschirmplatte (14) mindestens eine Öffnung aufweist, und der Halter (40, 23) durch die Öffnung der Abschirmplatte (14) verläuft, und
wobei ein Querschnitt der Öffnung größer als ein Querschnitt des Halters (40, 23) ist, so dass der Halter von der mindestens einen Abschirmplatte (14) beabstandet ist.

8. Felderzeugendes Element (1) nach einem der vorangehenden Ansprüche, ferner aufweisend
ein Kanal (23), welcher angepasst ist, eine vakuumdichte Leitung zur Fluidkommunikation der Innenseite des Behälters (21) und der Außenseite der Ladungsteilchenstrahlvorrichtung bereitzustellen.

9. Felderzeugendes Element (1) nach einem der vorangehenden Ansprüche, ferner aufweisend
ein Kanal (23), welcher aus wärmeleitfähigem Material gefertigt ist und angepasst ist, Wärme von der Innenseite des Behälters (21) zu einem Gehäuse (30) und/oder zur Außenseite der Ladungsteilchenstrahlvorrichtung zu leiten.

10. Felderzeugendes Element (1) nach Anspruch 8 oder 9, wobei
der Kanal (23) Versorgungsleitungen (22) für die mindestens eine Spule (20) aufnimmt.

11. Felderzeugendes Element (1) nach einem der Ansprüche 8 bis 10, wobei
der Kanal zwischen dem Behälter (21) und einem Gehäuse (30) der Ladungsteilchenstrahlvorrichtung montierbar ist.

12. Felderzeugendes Element (1) nach Anspruch 11, wobei
der Kanal an dem Gehäuse (30) der Ladungsteilchenstrahlvorrichtung montierbar und von außerhalb des Gehäuses (30) fixierbar ist.

13. Felderzeugendes Element (1) nach einem der Ansprüche 8 bis 12, wobei der Kanal (23) als der Halter (40) dient.

14. Felderzeugendes Element (1) nach einem der vorangehenden Ansprüche, wobei mindestens eine weitere Spule (20') in dem vakuumdichten Behälter (21) aufgenommen ist.

15. Felderzeugendes Element (1) nach einem der vorangehenden Ansprüche, wobei das Polstück (10) ein verlängertes Vorderteil (11) umfasst.

16. Felderzeugendes Element (1) nach einem der vorangehenden Ansprüche, wobei
besagtes Polstück (11, 10) ferner als eine Elektrode dient und mit einer Spanungsquelle (U1, U1') durch eine Spannungsversorgungsleitung verbunden ist, wobei das Polstück (10, 11) von dem Joch (12) elektrisch isoliert ist.

17. Felderzeugendes Element (1) nach Anspruch 16, wobei
das Joch (12) durch eine isolierende Folie (15) und Keramikbuchsen (17) vom Polstück (10, 11) elektrisch isoliert ist.

18. Felderzeugendes Element (1) nach einem der vorangehenden Ansprüche, wobei mindestens ein Teil einer hinteren Oberfläche (120) des Polstücks (10, 100) gekrümmt ist, wobei die Krümmung einer entsprechenden inneren Krümmung des Jochs (12) angepasst ist.

19. Felderzeugendes Element (1) nach einem der vorangehenden Ansprüche, wobei eine hinteren Oberfläche (120) des Polstücks (10, 100) planar ist.

20. Felderzeugendes Element (1) nach einem der vorangehenden Ansprüche, wobei die hintere Oberfläche (120) mindestens eine erhöhte Kontaktregion (130) umfasst, um mit dem Joch (12) in Kontakt zu sein.

21. Felderzeugendes Element (1) nach Anspruch 20, wobei mindestens eine erhöhte Kontaktregion (130) streifenförmig ist.

22. Felderzeugendes Element (1) nach Anspruch 20 oder 21, wobei mindestens eine erhöhte Kontaktregion (130) punktförmig ist.

23. Felderzeugendes Element (1) nach einem der vorangehenden Ansprüche, wobei
die Bestandteile des felderzeugenden Elements (1) miteinander lösbar verbunden sind, so dass das felderzeugende Element (1) auseinandergebaut werden kann und mit derselben Präzision und Genauigkeit wieder zusammengebaut werden kann.

24. Multipolelement mit einer Mehrzahl von felderzeugenden Elementen (1) nach einem der Ansprüche 1 bis 23.

25. Multipolelement nach Anspruch 24, wobei die Anzahl der felderzeugenden Elemente (1) gerade ist.

26. Multipolelement nach Anspruch 24 oder 25, wobei die vakuumdichten Behälter (21) der felderzeugenden Elemente (1) miteinander verbunden sind, um eine selbsttragende Struktur zu bilden.

27. Multipolelement nach Anspruch 26, wobei die vakuumdichten Behälter (21) der felderzeugenden Elemente (1) lösbar miteinander verbunden sind.

28. Multipolelement nach einem der Ansprüche 24 bis 27, wobei die Vakuumbehälter (21) durch Mikrokonnektoren miteinander elektrisch verbunden sind.

## Revendications

1. Elément (1) générateur de champ électromagnétique, comprenant :
une pièce polaire (10) ;
une carcasse (12) sur laquelle est fixée la pièce polaire (10) ;
au moins une bobine (20),
**caractérisé par**
un conteneur étanche au vide (21) recevant ladite au moins une bobine (20) et
un support (40,23) adapté à supporter le conteneur étanche au vide (21) de telle sorte que le conteneur étanche au vide (21) est espacé de la pièce polaire (10) et de la carcasse (12).

2. Elément générateur de champ (1) selon la revendication 1, dans lequel le conteneur étanche au vide (21) entoure la pièce polaire (10).

3. Elément générateur de champ (1) selon la revendication 1, dans lequel le conteneur étanche au vide (21) entoure la carcasse (12).

4. Elément générateur de champ (1) selon l'une quelconque des revendications précédentes, dans lequel le support (40,23) peut être fixé à un logement (30) de l'appareil à faisceau de particules chargées.

5. Elément générateur de champ (1) selon l'une quelconque des revendications précédentes, dans lequel
la carcasse (12) comprend au moins une ouverture (13), et le support (40,23) s'étend au travers de l'ouverture (13) de la carcasse (12), et
une section transversale de l'ouverture (13) est plus grande qu'une section transversale du support de telle sorte que le support (40,23) est espacé de la carcasse (12).

6. Elément générateur de champ (1) selon l'une quelconque des revendications précédentes, comprenant, en outre :
au moins une plaque de blindage (14) pour limiter les champs de dispersion, ladite au moins une plaque de blindage (14) étant espacée du conteneur étanche au vide (21).

7. Elément générateur de champ (1) selon la revendication 6, dans lequel :
ladite au moins une plaque de blindage (14) comprend au moins une ouverture, et le support (40,23) s'étend au travers de l'ouverture de la plaque de blindage (14), et
une section transversale de l'ouverture est plus grande qu'une section transversale du support (40,23) de sorte que le support est espacé de ladite au moins une plaque de blindage (14).

8. Elément générateur de champ (1) selon l'une quelconque des revendications précédentes, comprenant, en outre :
une conduite (23) adaptée à réaliser un conduit étanche au vide pour une communication de fluide entre l'intérieur du conteneur (21) et l'extérieur de l'appareil à faisceau de particules chargées.

9. Elément générateur de champ (1) selon l'une quelconque des revendications précédentes, comprenant, en outre :
une conduite (23) faite d'un matériau conducteur de la chaleur et adapté à conduire de la chaleur depuis l'intérieur du conteneur (21) vers un logement (30) et/ou vers l'extérieur de l'appareil à faisceau de particules chargées.

10. Elément générateur de champ (1) selon la revendication 8 ou 9, dans lequel
la conduite (23) héberge des lignes d'alimentation (22) pour ladite au moins une bobine (20).

11. Elément générateur de champ (1) selon l'une quelconque des revendications 8 à 10, dans lequel
la conduite peut être montée entre le conteneur (21) et un logement (30) de l'appareil à faisceau de particules chargées.

12. Elément générateur de champ (1) selon la revendication 11, dans lequel
la conduite peut être montée sur le logement (30) de l'appareil à faisceau des particules chargées et peut être fixée depuis l'extérieur du logement (30).

13. Elément générateur de champ (1) selon l'une quelconque des revendications 8 à 12, dans lequel la conduite (23) sert de support (40).

14. Elément générateur de champ (1) selon l'une quelconque des revendications précédentes, dans lequel au moins une autre bobine (20') est reçue dans le conteneur étanche au vide (21).

15. Elément générateur de champ (1) selon l'une quelconque des revendications précédentes, dans lequel la pièce polaire (10) comprend une pièce frontale allongée (11).

16. Elément générateur de champ (1) selon l'une quelconque des revendications précédentes, dans lequel
ladite pièce polaire (11,10) sert, en outre, d'électrode et connectée à une source de courant (U1, U1') par une ligne d'alimentation en courant, ladite pièce polaire (10,11) étant électriquement isolée de la carcasse (12).

17. Elément générateur de champ (1) selon la revendication 16, dans lequel
la carcasse (12) est électriquement isolée de la pièce polaire (10,11) par une feuille isolante (15) et des manchons céramiques (17).

18. Elément générateur de champ (1) selon l'une quelconque des revendications précédentes, dans lequel au moins une partie de la surface arrière (120) de la pièce polaire (10,100) est courbée, la courbure étant ajustée pour s'adapter à la courbure intérieure respective de la carcasse (12).

19. Elément générateur de champ (1) selon l'une quelconque des revendications précédentes, dans lequel une surface arrière (120) de la pièce polaire (10,100) est plane.

20. Elément générateur de champ (1) selon l'une quelconque des revendications précédentes, dans lequel la surface arrière (120) comprend au moins une région de contact élevée (130) pour être en contact avec la carcasse (12).

21. Elément générateur de champ (1) selon la revendication 20, dans lequel au moins une région de contact élevée (130) est en forme de bande.

22. Elément générateur de champ (1) selon la revendication 20 ou 21, dans lequel au moins une région de contact élevée (130) est en forme de point.

23. Elément générateur de champ (1) selon l'une quelconque des revendications précédentes, dans lequel
les composants de l'élément générateur de champ (1) sont montés amovibles les uns par rapport aux autres de sorte de l'élément générateur de champ (1) peut être désassemblé et ré-assemblé avec la même précision et exactitude.

24. Elément multipôle comprenant une pluralité d'éléments générateurs de champ (1) selon l'une quelconque des revendications 1 à 23.

25. Elément multipôle selon la revendication 24, dans lequel le nombre d'éléments générateurs de champ (1) est pair.

26. Elément multipôle selon la revendication 24 ou 25, dans lequel les conteneurs étanches au vide (21) des éléments générateurs de champ (1) sont connectés l'un à l'autre pour former une structure autoportante.

27. Elément multipôle selon la revendication 26, dans lequel les conteneurs étanches au vide (21) des éléments générateurs de champ (1) sont connectés l'un à l'autre de manière détachable.

28. Elément multipôle selon l'une quelconque des revendications 24 à 26, dans lequel les éléments générateurs de champ (1) sont connectés électriquement les uns aux autres par des microconnecteurs.
